(19) Europäisches Patentamt
European Patent Office
Office européen des brevets

(11) **EP 4 631 728 A1**

(12) **EUROPEAN PATENT APPLICATION**
published in accordance with Art. 153(4) EPC

(43) Date of publication:
**15.10.2025   Bulletin 2025/42**

(21) Application number: **22967877.6**

(22) Date of filing: **08.12.2022**

(51) International Patent Classification (IPC):
*B41F 15/00* (2006.01)     *H05K 13/00* (2006.01)

(52) Cooperative Patent Classification (CPC):
**B41F 15/00; H05K 13/00**

(86) International application number:
**PCT/JP2022/045315**

(87) International publication number:
**WO 2024/122031 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Fuji Corporation
Chiryu-shi, Aichi 472-8686 (JP)**

(72) Inventor: **KATO, Mitsuaki
Chiryu-shi, Aichi 472-8686 (JP)**

(74) Representative: **Grünecker Patent- und
Rechtsanwälte
PartG mbB
Leopoldstraße 4
80802 München (DE)**

(54) **OPERATION GUIDANCE DEVICE, OPERATION GUIDANCE SYSTEM, AND OPERATION GUIDANCE METHOD**

(57)     An object is to provide an operation guidance device capable of giving a preparation instruction in accordance with a time required for a screen printer for a member that is required to be delivered or collected.

An operation guidance device includes: a request time acquisition section configured to acquire, for a member used by a screen printer, a device request time including at least one of a delivery time when a new member is required to be delivered to the screen printer or a collection time when the member used by the screen printer is required to be collected; a setting section configured to set a departure target time when a departure from a departure place toward the screen printer is required in time for the device request time acquired by the request time acquisition section, and information on a target member that is the member that requires an operation at the device request time corresponding to the departure target time; and a display instruction section configured to, for operation instruction information in which two pieces of information, the departure target time set by the setting section and the information on the target member, are associated with each other, display a list of multiple pieces of the operation instruction information.

[Fig. 8]

## Description

Technical Field

The present disclosure relates to a technique for guiding delivery and collection of a member used in a screen printer.

Background Art

Patent Literature 1 describes a material management device that gives a preparation instruction to take out a solder pot containing cream solder from a material storage. The material management device of Patent Literature 1 creates a preparation instruction for the solder pot to be taken out from the material storage based on production plan information including a material type of the cream solder and information on a material status of the cream solder stored in the material storage. The material management device transmits the created preparation instruction to a mobile terminal of a worker.

Citation List

Patent Literature

Patent Literature 1:JP-A-2018-190871

Summary of the Invention

Technical Problem

In the screen printer that prints the cream solder on a board using a mask on which a printing pattern is formed, it is required to deliver or collect various members such as a mask and a squeegee in addition to the cream solder. In addition, when multiple production lines are collectively managed, it is required to arrange a member to be delivered or collected, for the screen printer installed in each production line. Therefore, there is a need for a technique of enabling the worker to give the preparation instruction in accordance with a time required for the screen printer for a member that is required to be delivered or collected.
The present disclosure has been made in view of the above-described issues, and an object of the present disclosure is to provide an operation guidance device, an operation guidance system, and an operation guidance method, which are capable of giving a preparation instruction in accordance with a time required for a screen printer for a member that is required to be delivered or collected.

Solution to Problem

In order to achieve the above-described object, the present description discloses an operation guidance device including: a request time acquisition section configured to acquire, for a member used by a screen printer, a device request time including at least one of a delivery time when a new member is required to be delivered to the screen printer or a collection time when the member used by the screen printer is required to be collected; a setting section configured to set a departure target time when a departure from a departure place toward the screen printer is required in time for the device request time acquired by the request time acquisition section, and information on a target member that is the member that requires an operation at the device request time corresponding to the departure target time; and a display instruction section configured to, for operation instruction information in which two pieces of information, the departure target time set by the setting section and the information on the target member, are associated with each other, display a list of multiple pieces of the operation instruction information.
In addition, in order to achieve the above-described object, the present description discloses an operation guidance system including: a screen printer; a line management device configured to manage a production line in which the screen printer is provided; a control device connected to each of multiple line management devices and configured to manage a production order in the production line managed by each of the multiple line management devices; a request time acquisition section configured to acquire, for a member used by the screen printer, a device request time including at least one of a delivery time when a new member is required to be delivered to the screen printer or a collection time when the member used by the screen printer is required to be collected; a setting section configured to set a departure target time when a departure from a departure place toward the screen printer is required in time for the device request time acquired by the request time acquisition section, and information on a target member that is the member that requires an operation at the device request time corresponding to the departure target time; and a display instruction section configured to, for operation instruction information in which two pieces of information, the departure target time set by the setting section and the information on the target member, are associated with each other, display a list of multiple pieces of the operation instruction information.

Further, the contents of the present disclosure are not limited to implementation as the operation guidance device or the operation guidance system, and are extremely useful even when implemented as an operation guidance method of displaying the operation instruction information.

Advantageous Effects of Invention

With the operation guidance device, the operation guidance system, and the operation guidance method of the present disclosure, it is possible to give the preparation instruction in accordance with the time required for the screen printer for the member that is required to be delivered or collected.

Brief Description of Drawings

Fig. 1 is a diagram illustrating a configuration of operation guidance system 10 of the present embodiment.
Fig. 2 is a schematic diagram and a partially enlarged view illustrating an example of operation guidance system 10 including printer 11.
Fig. 3 is a schematic diagram of accommodation device 40 and printer 11.
Fig. 4 is a diagram illustrating an operation of carrying screen mask M into accommodation device 40, and is a diagram illustrating a state where carrying-in-and-out section 47 is located at a release position.
Fig. 5 is a diagram illustrating an operation of carrying screen mask M into accommodation device 40, and is a diagram illustrating a state where carrying-in-and-out section 47 grips screen mask M at a grip position.
Fig. 6 is a diagram illustrating an operation of carrying screen mask M into accommodation device 40, and is a diagram illustrating a state where screen mask M is carried in.
Fig. 7 is a block diagram of operation guidance system 10.
Fig. 8 is a diagram illustrating a processing flow of displaying operation instruction information 73.
Fig. 9 is a diagram illustrating a list of operation instruction information 73 displayed on display terminal 6.
Fig. 10 is a conceptual diagram illustrating device request time T1, departure target time T2, and operation start target time T3.

Description of Embodiments

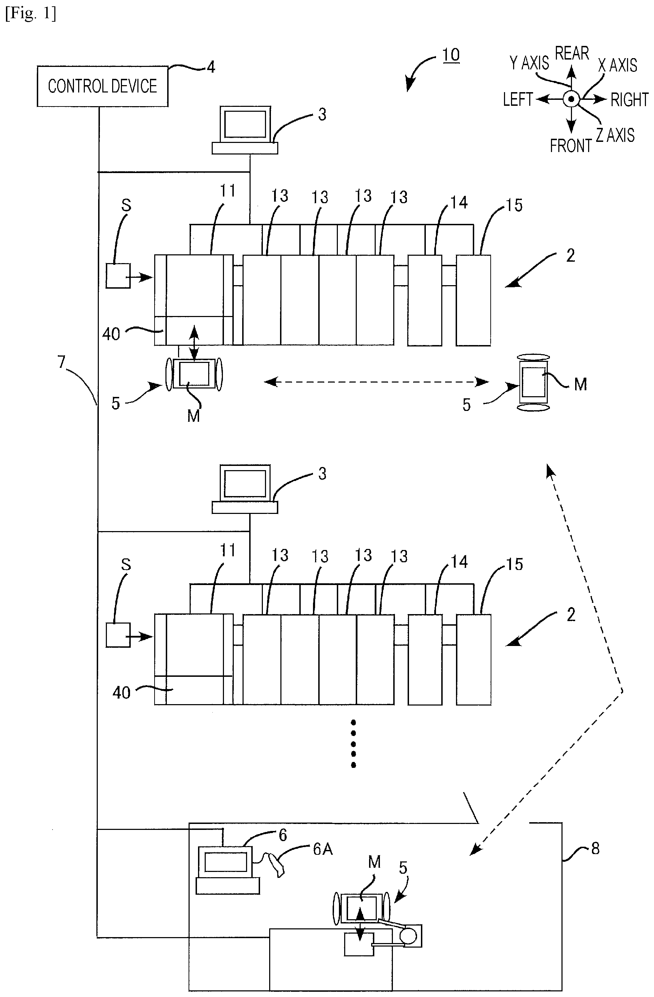

Hereinafter, an embodiment embodying an operation guidance system of the present disclosure will be described in detail with reference to the drawings. Fig. 1 illustrates a configuration of operation guidance system 10 of the present embodiment. As illustrated in Fig. 1, operation guidance system 10 includes multiple production lines 2, multiple line management devices 3, control device 4, automated guided vehicle 5, and display terminal 6. Production line 2 includes, for example, printer 11, mounting device 13, reflow oven 14, and board visual inspector 15 from an upstream side to a downstream side of production line 2. Operation guidance system 10 is a system that conveys board S from the upstream side to the downstream side of production line 2 and mounts components (such as electronic components) on board S. In the following description, as illustrated in Fig. 1, a direction in which board S is conveyed is referred to as a left-right direction (X-axis direction), a direction parallel to a plane of board S to be conveyed and perpendicular to the left-right direction is referred to as a front-rear direction (Y-axis direction), and a direction perpendicular to both the left-right direction and the front-rear direction is referred to as an up-down direction (Z-axis direction), with a direction (such as left and right) in which printer 11 is viewed from the front as a reference.

Printer 11 is a screen printer and is a device that prints viscous fluid, for example, cream-like solder (hereinafter, referred to as cream solder) on board S. The viscous fluid printed by printer 11 is not limited to the cream solder, and may be a printing agent having the same properties, for example, silver paste or an adhesive. Mounting device 13 is a device that mounts the component on board S on which the cream solder is printed. Reflow oven 14 is a device that heats board S on which the component is mounted, melts the cream solder, and then solidifies the cream solder. As a result, the component is mounted on board S. Board visual inspector 15 is a device that inspects a mounting state of board S on which the components are mounted.

Line management device 3 and control device 4 are communicably connected to each device of production line 2 via network 7. Line management device 3 is a device that manages production line 2, and manages a progress status of each device of production line 2. Each device of production line 2 exchanges information with line management device 3 and acquires information such as the progress status of another device. Control device 4 is a device that exchanges information with multiple line management devices 3 and manages a production order in each production line 2. Details of line management device 3 and control device 4 will be described later.

Automated guided vehicle 5 moves in a production facility provided with operation guidance system 10, and performs delivery of a member required in production line 2 and collection of a member after use. Control device 4 manages the members conveyed by automated guided vehicle 5, a current position of automated guided vehicle 5, and the like. In the present embodiment, a case will be described where a member (such as screen mask M described later) required for printer 11 is adopted as an example of the member required for production line 2. The production facility provided with operation guidance system 10 is provided with storage 8 that stores members required for production line 2. Automated guided vehicle 5 travels between storage 8 and production line 2 or in the production facility, and automatically conveys, for example, screen mask M. Automated guided vehicle 5 is an example of a conveyance device of the present disclosure. The members of the present disclosure are not limited to the members required for printer 11. The conveyance device of the present disclosure is not limited to a vehicle with wheels, and may be a device that travels by a movement mechanism other than wheels, such as a caterpillar. The conveyance device may be a flying device such as a drone. That is, the method of moving the conveyance device is not limited to the method of causing the conveyance device to travel on the floor of the production facility.

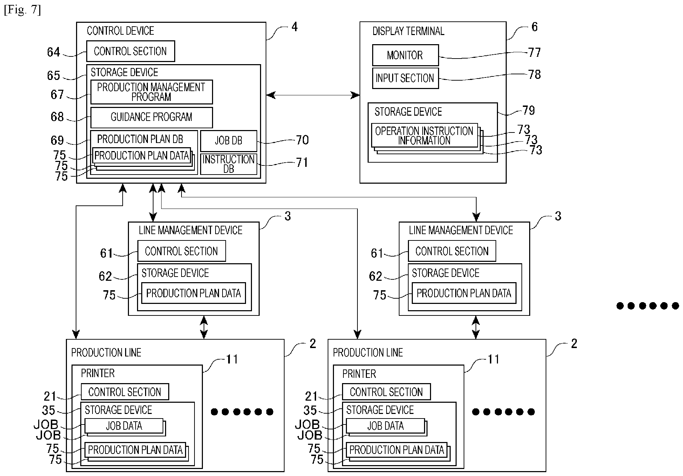

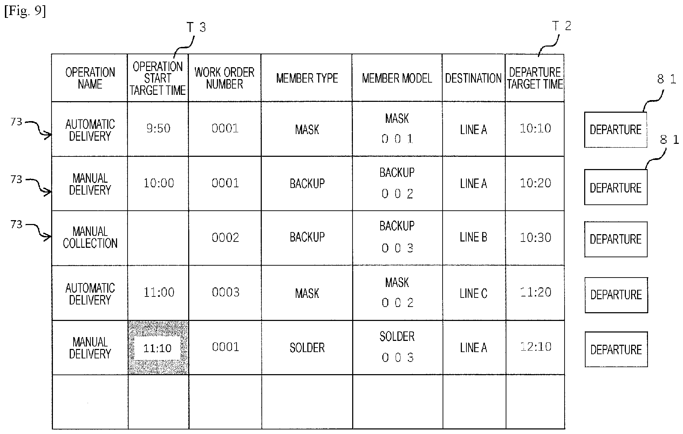

Display terminal 6 is, for example, a personal computer and is installed in storage 8. Display terminal 6 is connected to network 7 and displays information acquired from line management device 3, control device 4, and the like. This information is, for example, operation instruction information 73 (see Figs. 7 and 9) described later. Operation guidance system 10 causes display terminal 6 to display operation instruction information 73 instructing automated guided vehicle 5, which performs the automatic conveyance, to collect the member or prepare for delivery. A worker of storage 8 confirms operation instruction information 73 and performs delivery and collection of the member. Operation guidance system 10 of the present embodiment is a system in which both automated guided vehicle 5 and a person carry the member. Details of operation instruction information 73 will be described later. The device that displays operation instruction information 73 is not limited to a stationary device such as the above-described personal computer, and may be a portable device such as a laptop computer, a tablet terminal, or a smartphone.

The configuration of operation guidance system 10 illustrated in Fig. 1 is an example. For example, operation guidance system 10 may include only one production line 2 or only one line management device 3, or may include multiple control devices 4. Operation guidance system 10 may include a device other than the above-described devices, for example, a solder inspector that inspects an application state of the cream solder. Fig. 1 illustrates multiple automated guided vehicles 5, but operation guidance system 10 may include only one automated guided vehicle 5, or may include multiple, that is, two or more automated guided vehicles 5. Further, operation guidance system 10 may be a system that does not include automated guided vehicle 5 and causes a person to manually carry all members. In this case, the worker may manually carry the member while confirming operation instruction information 73, which will be described later.

(Automatic Exchange System of Screen Mask M)

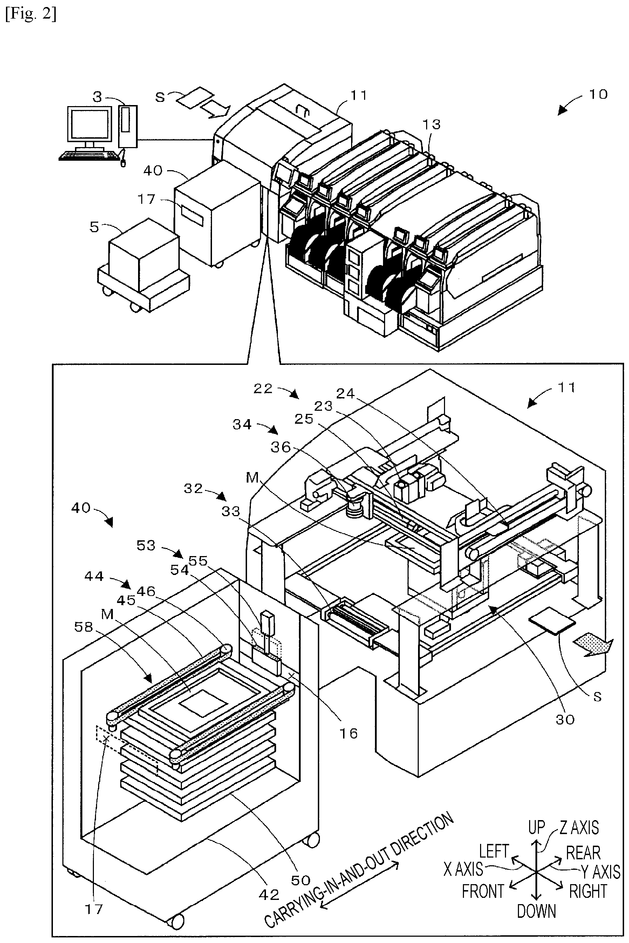

Next, a system that automatically exchanges screen mask M of printer 11 will be described. As a system that automatically exchanges screen mask M, for example, a system of International Publication WO2019/225002 can be adopted. Therefore, in the following description, an outline of the automatic exchange system will be described. Accommodation device 40 is connected to printer 11. Automated guided vehicle 5 temporarily accommodates the conveyed member (screen mask M in the present embodiment) in accommodation device 40. As illustrated in Figs. 2 to 6, printer 11 pushes the cream solder on screen mask M into pattern holes formed in screen mask M using squeegee 25, and thereby applying (printing) the cream solder onto lower board S via the pattern holes. In Fig. 2, reflow oven 14 and board visual inspector 15 are not illustrated.

Printer 11 includes control section 21 (see Fig. 7), printing section 22, mask operation section 26, board processing section 30, cleaning section 32, supply section 34, and storage device 35 (see Fig. 7). Control section 21 is, for example, a microprocessor such as CPU, executes a control program (not illustrated) stored in storage device 35 by the CPU, and controls entire printer 11. Storage device 35 includes, for example, RAM, ROM, and HDD. Storage device 35 stores job data JOB (see Fig. 7) used when board S is produced. Storage device 35 is not limited to the storage medium described above, and may be another storage medium such as SSD or a flash memory, or may be a combination thereof. Storage device 35 may be an external storage medium such as a USB memory or a storage medium such as CD-ROM or DVD-RAM. The same applies to other storage devices 62, 65, and 79 described later.

Printing section 22 is disposed at an upper part of printer 11 and is a unit that prints the cream solder on board S using screen mask M. As illustrated in the enlarged view of Fig. 2, printing section 22 includes printing head 23, printing moving section 24, and squeegee 25. Printing moving section 24 includes a guide formed in the front-rear direction, and moves printing head 23 in the front-rear direction. Squeegee 25 is a member that spreads the cream solder on screen mask M, and is disposed on a lower surface side of printing head 23. Printing section 22 is provided with a total of two squeegees 25 in the front-rear direction. Squeegee 25 is required to be exchanged in accordance with a size of board S to be produced. Mask moving section 27 is provided on the lower surface side of printing head 23. Mask moving section 27 is a rod for moving screen mask M by hooking screen mask M, and is lowered to a position in contact with screen mask M by an air cylinder (not illustrated).

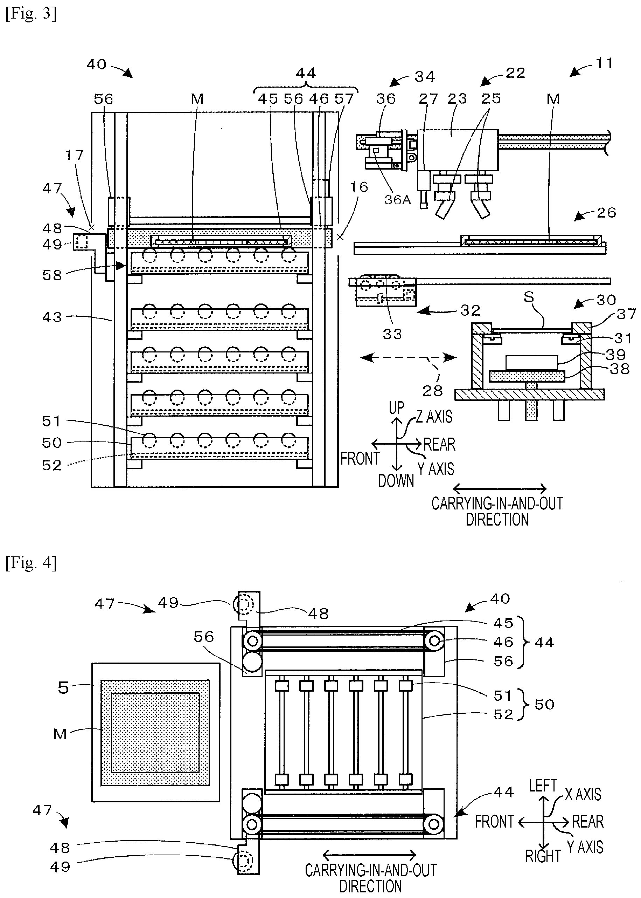

As illustrated in Fig. 3, mask operation section 26 is disposed between printing section 22 and board processing section 30 in the up-down direction, and positions and supports screen mask M in a horizontal posture. In a case of the exchange, screen mask M is pulled by mask moving section 27 provided in printing section 22, moves in the front-rear direction along the guide of mask operation section 26, and is fixed by mask operation section 26. Board processing section 30 is disposed below mask operation section 26, and includes board conveyance section 31, clamping device 37, and lifting and lowering table 38. Printer 11 has conveyance ports formed on both side surfaces in the left-right direction. Board conveyance section 31 conveys board S carried in from the conveyance port on the upstream side (left side) in the right direction and discharges board S from the conveyance port on the downstream side. Board conveyance section 31 conveys board S under screen mask M installed in the device. Clamping devices 37 are provided on both sides of board S in the front-rear direction. Lifting and lowering table 38 is lifted and lowered by a drive source (not illustrated) such as a motor or an air cylinder in a state where backup block 39 is placed on lifting and lowering table 38. Lifting and lowering table 38 clamps and fixedly holds board S between backup block 39 and clamping device 37 in the up-down direction, for example, by lifting backup block 39. Board processing section 30 lifts and lowers board S positioned by clamping device 37 by using a lifting and lowering mechanism (not illustrated) to bring board S into contact with screen mask M from below or separate board S from screen mask M.

Backup block 39 is a member for vacuum suction to correct deflection of board S. An air hose connected to a vacuum pump (not illustrated) is attached to lifting and lowering table 38. Board processing section 30 corrects the deflection of board S by evacuating the air chamber including backup block 39 by the vacuum pump. Backup block 39 is formed in accordance with the size of board S, and when there is a component attached to a back surface of board S in advance, a recessed portion is formed in accordance with the position of the component or the like. Therefore, backup block 39 is required to be exchanged in accordance with a type of board S to be produced. The member that clamps board S and corrects the deflection is not limited to backup block 39, and may be a columnar member such as a backup pin.

Cleaning section 32 is disposed between mask operation section 26 and board processing section 30 in the up-down direction, and cleans a back surface of screen mask M. Cleaning section 32 has cleaning member 33 and cleans the back surface of screen mask M with cleaning member 33. Cleaning member 33 is, for example, cleaning paper. Since cleaning member 33 is contaminated by cleaning, cleaning member 33 is required to be exchanged after a predetermined number of times of use, a predetermined period of use, or the like.

Supply section 34 is a unit for supplying the cream solder accommodated in cartridge 36 on screen mask M. Supply section 34 is disposed in front of printing head 23 and applies pressure to cartridge 36 to discharge the cream solder from cartridge 36. Cartridge 36 is required to be exchanged because the cream solder accommodated therein is reduced by repeating printing.

Cartridge 36 is provided with remaining amount detection sensor 36A (see Fig. 3) that detects a remaining amount of the cream solder. As remaining amount detection sensor 36A, for example, a liquid level sensor or a level switch that detects a height of a liquid level in a container of cartridge 36 can be used. Printer 11 detects the remaining amount of the cream solder in cartridge 36 based on a detection signal of remaining amount detection sensor 36A. The method of detecting the remaining amount of the cream solder is not limited to the method using remaining amount detection sensor 36A described above. For example, an image of the cream solder (kneaded solder roll) discharged from cartridge 36 onto screen mask M may be captured by a camera, an amount of used cream solder may be detected from the captured image data, and the remaining amount may be calculated from the used amount.

Since screen mask M has different pattern holes in accordance with the printing pattern, it is required to exchange screen mask M with a different printing pattern in accordance with the type of board S to be produced. In addition, since the cream solder adheres to screen mask M when screen mask M is repeatedly used, screen mask M is required to be cleaned and is required to be exchanged with screen mask M having the same printing pattern. As described above, squeegee 25 and backup block 39 are required to be exchanged in accordance with the type of board S. Further, cartridge 36 and cleaning member 33 are required to be exchanged with consumption and contamination. In operation guidance system 10 of the present embodiment, screen mask M can be automatically exchanged by automated guided vehicle 5. Remaining squeegee 25, backup block 39, cartridge 36, and cleaning member 33 can be manually exchanged by the worker. Then, control device 4 displays, on display terminal 6, operation instruction information 73 for delivery for exchange of these members and collection of the members after use, and gives an instruction to the worker. The worker exchanges screen mask M, which is an automatic exchange target, by using automated guided vehicle 5. In addition, the worker prepares other members that require manual exchange in accordance with the instructed time period, moves the prepared members to printer 11, and performs the exchange. Alternatively, only the member may be conveyed by automated guided vehicle 5, and another worker in front of printer 11 may receive the member from automated guided vehicle 5 and manually exchange the member. In this case, members other than screen mask M may be configured to be accommodated in accommodation device 40, and the members other than screen mask M may be delivered between accommodation device 40 and automated guided vehicle 5. Further, automated guided vehicle 5 may be configured to convey multiple, that is, two or more members. Only one screen mask M or another member may be conveyed. Therefore, the member exchange method (manual or automatic) and the member conveyance method (automated guided vehicle 5 or person) of the present disclosure can be changed as appropriate.

The member that is the automatic exchange target and the member that is a manual exchange target are examples. For example, as indicated by dashed arrow 28 in Fig. 3, backup block 39 may be exchanged between printer 11 and accommodation device 40 to automatically perform the exchange. In this case, backup block 39 may be conveyed and exchanged in the same manner as the conveyance of screen mask M by automated guided vehicle 5 described later. Further, operation guidance system 10 may be configured such that all members that are the exchange targets can be automatically exchanged, or may be configured such that all members are manually exchanged. The members of the present disclosure are not limited to screen mask M, backup block 39, squeegee 25, and the like described above. For example, the member that is the exchange target may be a solder collection plate that collects the cream solder remaining on screen mask M. Such a solder collection plate also is required to be exchanged because the solder collection plate is required to be changed in accordance with the type of the board or to be periodically cleaned.

Accommodation device 40 is disposed in front of printer 11, accommodates screen mask M, and carries screen mask M into and out of printer 11 and automated guided vehicle 5. Accommodation device 40 includes accommodation section 42, placement section moving section 43, pair of target object moving sections 44, pair of carrying-in-and-out sections 47, placement section 50, and door section 53. Accommodation section 42 is formed inside a housing of accommodation device 40, has delivery stage 58 that delivers screen mask M to and from printer 11, accommodates multiple (for example, five) placement sections 50, and accommodates screen mask M in each placement section 50. In accommodation section 42, opening section 16 through which screen mask M passes is formed on printer 11 side of delivery stage 58. Further, carrying-in-and-out port 17 through which screen mask M passes is formed on automated guided vehicle 5 side of delivery stage 58 in accommodation section 42. As illustrated in Fig. 3, placement section moving section 43 includes support sections that support placement section 50 at predetermined intervals in the up-down direction (Z-axis direction), and lifts and lowers placement section 50 in the up-down direction by a drive source (not illustrated) to exchange placement section 50 of delivery stage 58.

Placement section 50 is a shelf on which screen mask M is placed, and includes support roller 51 and plate 52. Support roller 51 supports screen mask M from below and rotates in accordance with the movement of screen mask M. Plate 52 is a member that is disposed below support roller 51, is detachably attached to placement section 50, and receives the viscous fluid dropped from screen mask M.

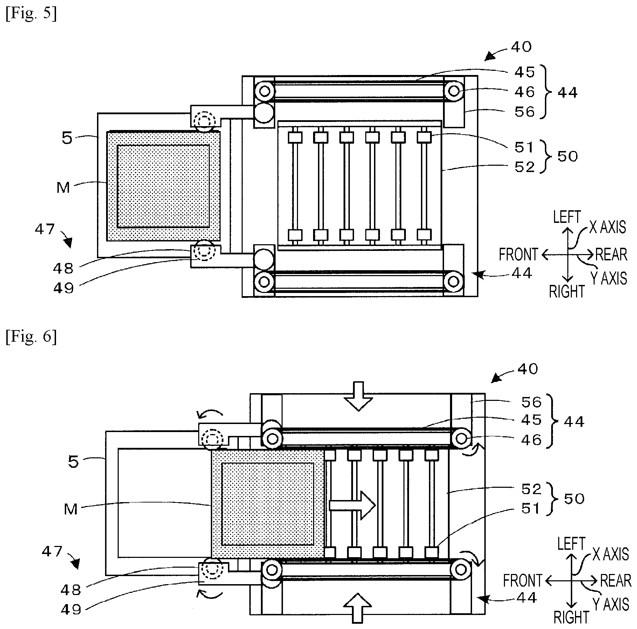

Pair of target object moving sections 44 abut on screen mask M and move screen mask M in carrying-in-and-out direction (Y-axis direction or front-rear direction). As illustrated in Fig. 3, pair of target object moving sections 44 are disposed on delivery stage 58, and as illustrated in Fig. 4, pair of target object moving sections 44 are provided on both sides of placement section 50 of delivery stage 58 in the left-right direction (X-axis direction). Each of pair of target object moving sections 44 has the same configuration, and for example, has a symmetrical configuration in the left-right direction. As illustrated in Figs. 3 and 4, each of pair of target object moving sections 44 includes multiple conveyance rollers 46, belt 45 wound around conveyance rollers 46, pair of retreat drive sections 56, and conveyance drive section 57. Pair of retreat drive sections 56 are provided, for example, at both ends of placement section 50 in the front-rear direction. Each of pair of retreat drive sections 56 is connected to conveyance roller 46, and drives a drive source (such as an air cylinder) to move belt 45 and conveyance roller 46 in the left-right direction. Each of pair of retreat drive sections 56 moves belt 45 and conveyance roller 46 to a contact position (see Fig. 6) at which screen mask M and belt 45 are brought into contact with each other or a retreat position (see Fig. 4) separated from screen mask M.

Conveyance drive section 57 is a motor that rotates conveyance roller 46. Pair of target object moving sections 44 move screen mask M in one of the carrying-in-and-out directions by rotating conveyance roller 46 to rotate belt 45 at the contact position. In addition, pair of target object moving sections 44 move belt 45 and conveyance roller 46 to the retreat position when placement section 50 is lifted and lowered. Figs. 4 and 5 illustrate a state where pair of target object moving sections 44 are disposed at the retreat position, and Fig. 6 illustrates a state where pair of target object moving sections 44 are disposed at the grip position.

Pair of carrying-in-and-out sections 47 are disposed on delivery stage 58, and are provided on both sides of placement section 50 of delivery stage 58 in the left-right direction and at the front end. Pair of carrying-in-and-out sections 47 carry screen mask M into and out of automated guided vehicle 5. Pair of carrying-in-and-out sections 47 project from accommodation section 42 to the outside, and thereby pulling screen mask M from automated guided vehicle 5 into accommodation section 42 or feeding out screen mask M from accommodation section 42 to automated guided vehicle 5. Automated guided vehicle 5 may include carrying-in-and-out section 47 that feeds out and draws in screen mask M. Both accommodation device 40 and automated guided vehicle 5 may include a device that moves screen mask M. Automated guided vehicle 5 may directly deliver screen mask M to and from printer 11. In this case, printer 11 need not include accommodation device 40.

Each of pair of carrying-in-and-out sections 47 has the same configuration and includes gripping member 48 and carrying-in-and-out roller 49. Further, as illustrated in Figs. 4 and 5, pair of carrying-in-and-out sections 47 are configured to rotate, and rotate gripping member 48 between a grip position (see Fig. 5) at which screen mask M of automated guided vehicle 5 is gripped and a release position (see Fig. 4) separated from screen mask M. Carrying-in-and-out roller 49 is provided at a distal end of gripping member 48, abuts on screen mask M, and rotates based on driving of a motor (not illustrated) to move screen mask M in the carrying-in-and-out direction.

Door section 53 is a shutter unit that restricts the movement of screen mask M to the outside. As illustrated in Fig. 2, door sections 53 are disposed at two positions near opening section 16 and near carrying-in-and-out port 17. In Fig. 2, door section 53 disposed in carrying-in-and-out port 17 is not illustrated. Door section 53 moves shielding plate 54 in the up-down direction by opening and closing drive section 55 (motor or the like). Door section 53 moves shielding plate 54 between a restriction position (solid line in Fig. 2) at which the movement of delivery stage 58 in the carrying-in-and-out direction of screen mask M is regulated and an open position (dotted line in Fig. 2) at which the movement is possible.

Figs. 4 to 6 illustrate an operation of carrying screen mask M into accommodation device 40. Automated guided vehicle 5 moves, for example, in a state where screen mask M is placed at a height of delivery stage 58. As illustrated in Fig. 4, automated guided vehicle 5 is disposed in front of accommodation device 40. For example, control device 4 constantly manages a position of automated guided vehicle 5. The method of detecting the position of automated guided vehicle 5 is not particularly limited, but a method using a GPS, a method of detecting the position by a sensor or the like provided in production line 2 or automated guided vehicle 5, a method of detecting the position by image processing using a camera provided in the production facility, or the like can be used.

When automated guided vehicle 5 is disposed in front of printer 11 (accommodation device 40) that delivers and collects screen mask M, control device 4 instructs accommodation device 40 to carry in or discharge screen mask M. For example, when carrying in screen mask M, accommodation device 40 opens shielding plate 54 of carrying-in-and-out port 17. Accommodation device 40 moves pair of carrying-in-and-out sections 47 from the release position (see Fig. 4) to the grip position (see Fig. 5), and grips screen mask M on automated guided vehicle 5 with pair of carrying-in-and-out sections 47. Accommodation device 40 moves belt 45 and conveyance roller 46 to the contact position and rotates carrying-in-and-out roller 49 and conveyance roller 46 to carry screen mask M from automated guided vehicle 5 to placement section 50 of delivery stage 58 (see Fig. 6). Accommodation device 40 moves shielding plate 54 of carrying-in-and-out port 17 to the restriction position to restrict the movement of screen mask M to the outside. When screen mask M is discharged, for example, screen mask M can be discharged from accommodation device 40 to automated guided vehicle 5 by performing an operation (reverse rotation or the like) opposite to the operation illustrated in Figs. 4 to 6.

Further, printer 11 and accommodation device 40 can carry in screen mask M from accommodation device 40 to printer 11 and discharge screen mask M from printer 11 to accommodation device 40. Although details are omitted, for example, accommodation device 40 opens shielding plate 54 of opening section 16 and rotates conveyance roller 46 to discharge screen mask M to printer 11, similarly to the delivery of screen mask M to and from automated guided vehicle 5. Printer 11 disposes screen mask M in printer 11 (to mask operation section 26) by mask moving section 27 by hooking mask moving section 27 provided in printing section 22 on an end portion of screen mask M and drawing in printing section 22 rearward. When screen mask M is discharged from printer 11 to accommodation device 40, printer 11 pushes used screen mask M to delivery stage 58 of accommodation device 40 by mask moving section 27. Accommodation device 40 can draw in screen mask M by rotating belt 45 in a direction opposite to the discharge direction. In this way, printer 11, accommodation device 40, and automated guided vehicle 5 of the present embodiment can perform the automatic conveyance and the automatic exchange of screen mask M. As described above, the member to be automatically exchanged is not limited to screen mask M, and for example, as indicated by dashed arrow 28 in Fig. 3, backup block 39 may be automatically exchanged by being exchanged between it and accommodation device 40.

(Operation Guidance System 10)

Fig. 7 is a block diagram of operation guidance system 10. As illustrated in Fig. 7, line management device 3 is, for example, a personal computer including control section 61 such as CPU and storage device 62. Line management device 3 manages the production in production line 2 based on a production management plan of board S managed by control device 4. Storage device 62 is used to store production plan data 75 described later.

Control device 4 is, for example, a server device including control section 64 such as CPU and storage device 65. Storage device 65 stores production management program 67, guidance program 68, production plan DB 69, job DB 70, and instruction DB 71. Production management program 67 is a program for managing the production order of each production line 2. Guidance program 68 is a program for changing information to be displayed on display terminal 6 based on information (lists L1 to L5 described later) collected from line management device 3 of each production line 2, specifically, operation instruction information 73 described later.

Storage device 65 stores data required to create production plan data 75. Specifically, the data is information on the model of board S or each member. The model is, for example, information on a member (product) required to produce board S of production plan data 75. In a case of board S, the model is information on a model name of board S. When the member is the cream solder, the model is information on a model (product name or the like) of the cream solder. The worker operates control device 4, refers to the data in storage device 65, selects a model such as a board type, a solder type, or a component type in accordance with the production plan, and creates production plan data 75. Control device 4 creates production plan data 75 based on the operation input of the worker and registers production plan data 75 in production plan DB 69. Production plan data 75 is, for example, information for instructing production line 2 on the model of the member or board S to be used, a production start time, and the number of productions. Therefore, production plan data 75 stores information indicating a production instruction to each device of production line 2 such as printer 11 and mounting device 13. In the following description of production plan data 75, printer 11 will be mainly described.

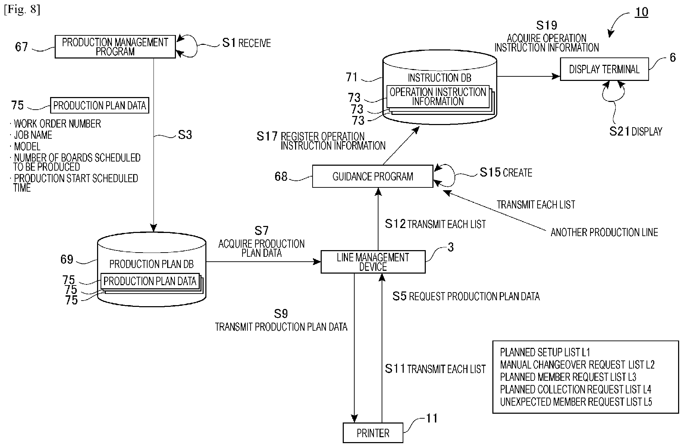

Production plan data 75 is managed by, for example, an identification number called a work order number. In production plan data 75, for example, information on a job name, a number of boards scheduled to be produced, and a production start scheduled time is stored in association with the work order number in addition to the model described above (see Fig. 8). In the information on the model, information on the model of the member or board S used for the production, for example, information on the model of squeegee 25 or the like is set in addition to the model of the cream solder described above. The job name is the name of job data JOB. Job data JOB is control data for controlling each device (printer 11 and mounting device 13) of production line 2 in the production of production plan data 75. In a case of printer 11, job data JOB is, for example, information on a movement start position of squeegee 25 in accordance with the size of board S. In a case of mounting device 13, job data JOB is information on a mounting position of the component. For example, in job DB 70, multiple job data JOB corresponding to the types of board S are stored. Each device of production line 2 acquires job data JOB of the job name indicated by production plan data 75 from job DB 70 before starting the production, and uses job data JOB for the production. In instruction DB 71, operation instruction information 73 to be displayed on display terminal 6 is registered. The production start scheduled time is a time scheduled to start the production of board S. In the present embodiment, for example, a time indicating any time point without a temporal width is referred to as "XX time", and a time indicating a predetermined temporal width is referred to as "XX time period".

Display terminal 6 is a personal computer including CPU (not illustrated) and the like, and includes monitor 77, input section 78, and storage device 79. Monitor 77 is, for example, an LCD panel. Input section 78 is, for example, a mouse or a keyboard. Display terminal 6 acquires operation instruction information 73 from instruction DB 71, stores operation instruction information 73 in storage device 79, and displays operation instruction information 73 on monitor 77.

(Display of Operation Instruction Information 73)

Next, a flow of processing in which operation guidance system 10 displays operation instruction information 73 on display terminal 6 will be described with reference to Fig. 8. In the following description, a device that executes a program is described by a device name or a program name. For example, "production management program 67 writes to production plan DB 69" indicates that control device 4 that executes production plan DB 69 by control section 64 writes to production plan DB 69". In the following description, in order to avoid complication of the drawing, printer 11 of one production line 2 will be mainly described as illustrated in Fig. 8. However, it is possible to collect information in the same manner for printers 11 of other production lines 2 and display operation instruction information 73 collectively for each production line 2.

First, in step (hereinafter, simply referred to as S) 1 illustrated in Fig. 8, the worker who operates control device 4 registers new production plan data 75. Production management program 67 receives an operation input of the worker (S1), creates production plan data 75 in accordance with the received operation input, and registers created production plan data 75 in production plan DB 69 (S3). As described above, for example, the work order number, the job name, the model, the number of boards scheduled to be produced, and the production start scheduled time are set in production plan data 75. The content of production plan data 75 described above is an example. For example, production plan data 75 may include information designating production line 2 that produces board S, for example, identification information of designated production line 2.

For example, the worker confirms the current progress status of the production of each production line 2 with control device 4, and sets the production start scheduled time of production plan data 75. However, in some cases, actual production does not proceed in accordance with the production plan because the production proceeds faster than expected or is delayed due to the occurrence of an error or the like. As a result, there is a possibility that the collection or delivery of the member is accelerated and automated guided vehicle 5 enters a standby state in front of printer 11, or the collection or delivery of the member is delayed and the production efficiency is reduced. Therefore, operation guidance system 10 can perform more optimal collection and delivery by displaying operation instruction information 73 in consideration of the actual production status of printer 11.

As illustrated in Fig. 7, printer 11 stores, for example, two production plan data 75 in storage device 35. Two production plan data 75 are production plan data 75 of the production being currently performed and production plan data 75 of the production scheduled next. For example, printer 11 acquires production plan data 75 of the production after the next at the end of the production based on production plan data 75 of the production being currently performed (S5). For example, printer 11 estimates a changeover time when the production of board S is completed and a type of board S to be produced is changed, that is, a so-called changeover occurs, based on the number of boards scheduled to be produced of production plan data 75 of the production being currently performed, the number of produced boards which is the number of boards S of which the production is completed at the present time in the number of boards scheduled to be produced, and a unit production time period required to produce one board S. Specifically, the changeover time can be calculated by the following equation.

Changeover time = (number of boards scheduled to be produced - number of produced boards) * unit production time period

As the unit production time period, for example, a set value (theoretical value, target value, or the like) set in advance in accordance with the board type may be used, or an actual measurement value (average value or the like) actually measured during the production of board S may be used. The unit production time period is preferably set to a time period in consideration of a cleaning time period by cleaning section 32 in addition to a printing time period for printing on board S. For example, the cleaning is performed by cleaning section 32 each time four boards are printed by printer 11, and a time period required for the cleaning operation is set as the cleaning time period. Further, a time period required to print one sheet is defined as the printing time period. In this case, the unit production time period can be expressed by the following equation by converting the cleaning time period per sheet.

$$\text{Unit production time period} = \text{printing time period} + \text{cleaning time period}/4$$

Printer 11 may use a substantial unit production time period in consideration of the cleaning time period as the unit production time period used for estimating the changeover time. For example, when a time reaches the estimated changeover time, that is, a time going back (before) from an end time of the production by a predetermined time period, printer 11 requests production plan data 75 of the production after the next to line management device 3 (S5). Printer 11 notifies line management device 3 of the work order number of production plan data 75 of the production being currently performed and information indicating the request.

When line management device 3 receives the request of S5 from printer 11, line management device 3 acquires production plan data 75 of the production after the next from production plan DB 69 based on the work order number (S7), and transmits production plan data 75 of the production after the next to printer 11 (S9). The method of acquiring production plan data 75 is not particularly limited. For example, in the acquisition of production plan data 75, line management device 3 may notify control device 4 of the work order number received from printer 11 and receive an instruction as to which work order number of production plan data 75 is to be acquired as production plan data 75 of the production after the next. Alternatively, line management device 3 may acquire production plan data 75 having the earliest production start scheduled time in production plan data 75 registered in production plan DB 69 in S7. Line management device 3 may preferentially acquire production plan data 75 to which the identification number of production line 2 managed by line management device 3 is assigned. The changeover time may be estimated by a device (line management device 3 or control device 4) other than printer 11. For example, line management device 3 may acquire the number of produced boards from printer 11 to estimate the changeover time, and acquire production plan data 75 of the production after the next and transmit production plan data 75 of the production after the next to printer 11 at a time going back from the changeover time by a predetermined time period.

Meanwhile, printer 11 creates five lists required to create operation instruction information 73 as appropriate, and notifies guidance program 68 (control device 4) of the five lists via line management device 3 (S11, S12). Control device 4 creates operation instruction information 73 based on the lists (S15), and registers created operation instruction information 73 in instruction DB 71 (S17). Five lists are, for example, planned setup list L1, manual changeover request list L2, planned member request list L3, planned collection request list L4, and unexpected member request list L5. These lists are collectively referred to as lists L1 to L5. A part or all of the processing of creating lists L1 to L5 may be executed by a device other than printer 11 (line management device 3 or control device 4). Printer 11 may directly transmit lists L1 to L5 to control device 4 (guidance program 68) without going through line management device 3.

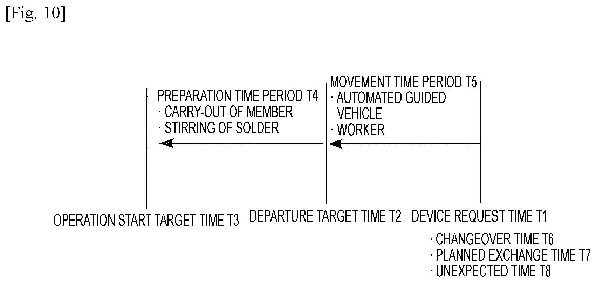

Planned setup list L1 is a list for requesting a member that is newly required along with the changeover and that can be automatically exchanged, that is, screen mask M in the present embodiment. Manual changeover request list L2 is a list for requesting a member that is newly required along with the changeover and that is manually exchanged, that is, a member other than screen mask M in the present embodiment. As described above, printer 11 estimates the changeover time by multiplying a difference between the number of boards scheduled to be produced and the number of produced boards by the unit production time period. Printer 11 acquires job data JOB of production plan data 75 of the next production when a time reaches a time going back from (before) the estimated changeover time by a predetermined time period. The predetermined time period is preferably set to a time period equal to or longer than a time period obtained by adding preparation time period T4 and movement time period T5 (see Fig. 10), similarly to planned member request list L3 described later. That is, as will be described later, it is preferable to set a predetermined time period in which planned setup list L1 and manual changeover request list L2 can be created and transmitted a predetermined time period before such that the member is delivered before the changeover time. Printer 11 acquires job data JOB based on the job name set in production plan data 75. A timing of acquiring job data JOB is not limited to the time period before the changeover time by the predetermined time period. For example, printer 11 may acquire job data JOB of the job name set in acquired production plan data 75 (production plan data 75 of the production after the next) at the timing when production plan data 75 is acquired in S9. In this case, printer 11 may create planned setup list L1 and manual changeover request list L2, which will be described later, and transmit planned setup list L1 and manual changeover request list L2 to guidance program 68 at a time point when production plan data 75 of the production after the next is acquired or at a time point when the production of production plan data 75 (production plan data 75 of the next production) immediately before production plan data 75 of the production after the next is started.

For example, printer 11 accesses job DB 70 of control device 4 and acquires job data JOB matching the job name set in production plan data 75 of the next production. In job data JOB, the name (model or the like) of the member used when board S is produced using job data JOB is set. Specifically, the names of screen mask M, backup block 39, the cream solder, squeegee 25, and the like are used. Printer 11 detects a member having a name different from the name of the member set in job data JOB of board S currently being produced among the names of the members set in job data JOB to be used for the next production, that is, a member (an example of a target member of the present disclosure) newly required in the changeover. When the detected newly required member is screen mask M, printer 11 writes the name of screen mask M and the changeover time in planned setup list L1, and transmits the name of screen mask M and the changeover time to guidance program 68 via line management device 3 (S11, S12). When the detected newly required member is a member other than screen mask M, printer 11 writes the name of the member (such as squeegee 25) and the changeover time in manual changeover request list L2, and transmits the name of the member and the changeover time to guidance program 68 via line management device 3 (S11, S12). Although printer 11 detects a newly required member using job data JOB, the present disclosure is not limited thereto. For example, printer 11 may detect a newly required member using production plan data 75. Printer 11 may detect a member having a name different from the name of the member set in production plan data 75 of board S currently being produced among the names of the members set in production plan data 75 of the next production as a member newly required for the changeover.

Guidance program 68 creates operation instruction information 73 based on planned setup list L1 and manual changeover request list L2 received from printer 11 (S15), and registers created operation instruction information 73 in instruction DB 71 (S17). For example, display terminal 6 periodically accesses instruction DB 71. When detecting the access of display terminal 6, printer 11 causes it to acquire operation instruction information 73 (S19), and display a list of operation instruction information 73 on monitor 77 (see Fig. 7) (S21).

Fig. 9 illustrates an example of a list of operation instruction information 73 displayed on monitor 77. As illustrated in Fig. 9, information on an operation name, operation start target time T3, the work order number, the member type, the member model, a destination, and departure target time T2 is set in operation instruction information 73. For example, guidance program 68 arranges each piece of operation instruction information 73 for each row, and displays multiple pieces of operation instruction information 73 arranged vertically as a list on display terminal 6. The operation name is information indicating the type of the operation in operation instruction information 73. In the present embodiment, automatic delivery, manual delivery, automatic collection, and manual collection are set as the operation names. The automatic delivery indicates an operation of delivering a member as a target (hereinafter, referred to as a target member) indicated by operation instruction information 73 by automated guided vehicle 5. In the present embodiment, the delivery of screen mask M corresponds to the automatic delivery. The manual delivery indicates that the worker holds the target member by hand and delivers the target member from storage 8 to printer 11. In the present embodiment, squeegee 25, cartridge 36, cleaning member 33, and backup block 39 correspond thereto. The automatic collection indicates an operation of collecting screen mask M from printer 11 to storage 8 by automated guided vehicle 5. The manual collection indicates that the worker manually collects the target members other than screen mask M from printer 11 to storage 8. The types of the operation names described above are examples. For example, only the delivery and the collection may be set as the operation name, and the distinction between automatic and manual may be eliminated.

Fig. 10 illustrates a relationship between each time period and time. Guidance program 68 acquires and sets device request time T1 based on received lists L1 to L5. Device request time T1 is a delivery time when a new target member is required to be delivered to printer 11 or a collection time when a used target member is required to be collected. For example, guidance program 68 sets changeover time T6 (an example of a delivery time of the present disclosure) set in planned setup list L1 or manual changeover request list L2 received from printer 11 as device request time T1.

In a case of planned setup list L1, automated guided vehicle 5 performs the automatic delivery, and in a case of manual changeover request list L2, the worker performs the manual delivery. Therefore, guidance program 68 sets movement time period T5 required to convey the target member in accordance with planned setup list L1 or manual changeover request list L2. In a case of planned setup list L1, guidance program 68 sets a time period required for automated guided vehicle 5 to move from storage 8 to target printer 11 as movement time period T5. The method of setting movement time period T5 is not particularly limited. For example, movement time period T5 required for automated guided vehicle 5 to move from storage 8 to printer 11 of each production line 2 is set in storage device 65. Further, printer 11 sets information on printer 11 in planned setup list L1. Then, guidance program 68 may detect printer 11 of a delivery destination from the information on the device set in planned setup list L1, and acquire and set movement time period T5 suitable for detected printer 11 from storage device 65. Similarly, in a case of manual changeover request list L2, guidance program 68 sets a time period required for the worker to move from storage 8 to target printer 11 as movement time period T5. Guidance program 68 sets a time going back from device request time T1 (changeover time T6) by movement time period T5 as departure target time T2 of operation instruction information 73. That is, guidance program 68 sets, as departure target time T2, a time period when the departure from storage 8 is required in time for changeover time T6. As illustrated in Fig. 9, display terminal 6 displays departure target time T2 in association with each piece of operation instruction information 73.

Further, guidance program 68 sets a time going back from departure target time T2 by preparation time period T4 as operation start target time T3 of operation instruction information 73. Preparation time period T4 is a time period required for the worker to prepare the target member. For example, when the target member is screen mask M, preparation time period T4 is a time period required for the worker to search for the shelf of storage 8, carry out target screen mask M, and set target screen mask M on automated guided vehicle 5. When the target member is squeegee 25, cleaning member 33, or backup block 39, preparation time period T4 is a time period required for the worker to search for the shelf of storage 8 and take out the target member. When the target member is the cream solder, preparation time period T4 is a time period required to take out the cream solder stored in a refrigerator and returning the cream solder to room temperature or a time period required for stirring. As such preparation time period T4, for example, a standard or ideal operation time period can be set in advance. Alternatively, as preparation time period T4, an actual measurement value actually measured by the worker in the operation environment can be set. As illustrated in Fig. 9, display terminal 6 displays operation start target time T3 in association with each piece of operation instruction information 73.

As illustrated in Fig. 9, the member type of operation instruction information 73 is information (mask, backup, or the like) indicating the type of the target member. The member model is information indicating the model of the target member. Guidance program 68 can set information on the member type and the member model in operation instruction information 73 based on, for example, the name of the member set in planned setup list L1 or manual changeover request list L2. The destination is identification information of production line 2 of the delivery destination or the collection destination. Guidance program 68 can set information on the destination from, for example, information on a transmission source such as planned setup list L1.

Planned member request list L3 is a list for requesting a target member that is required to be periodically exchanged due to consumption or the like. Among the members used in printer 11, there is a member that is required to be exchanged each time the threshold number of boards S are printed. For example, since the cream solder gradually adheres to screen mask M when the printing is repeated, periodic cleaning is required. For example, screen mask M is required to be cleaned when only 1000 boards S are printed. In this case, after screen mask M is exchanged, planned exchange time T7 when the exchange is required next can be expressed by the following equation using the current time and the unit production time period. The 1000 boards are an example of a threshold number of boards of the present disclosure.

$$\text{Planned exchange time } T7 = \text{current time} + 1000 * \text{unit production time period}$$

Similarly, the remaining amount of cartridge 36 runs out after printing the predetermined threshold number of boards. The capacity of the cream solder contained in unused cartridge 36 is defined as an initial capacity. In addition, an amount of the cream solder consumed in the printing on one sheet is set as an expected consumption. In this case, after cartridge 36 is exchanged, planned exchange time T7 when the exchange is required next can be expressed by the following equation using the current time and the unit production time period.

$$T7 = \text{current time} + (\text{initial capacity/expected consumption}) * \text{unit production time period}$$

The initial capacity can be set in advance in accordance with the size of cartridge 36. The expected consumption can be set in advance based on a simulation result or an actual measurement value. In this case, a value of (initial capacity/expected consumption) is an example of a threshold number of boards of the present disclosure.

Similarly, for example, cleaning member 33 is used in a cleaning process for every predetermined number of printed boards, and is required to be exchanged with a new member when the predetermined threshold number of boards are printed. Therefore, similarly to screen mask M, planned exchange time T7 can be calculated by multiplying the unit production time period by the threshold number of boards required to be exchanged and adding a value of the multiplication result to the current time. Printer 11 creates and transmits planned member request list L3 at a time going back from planned exchange time T7 calculated by the above-described calculation by a predetermined time period. The predetermined time period is preferably set to a time period equal to or longer than a time period obtained by adding preparation time period T4 and movement time period T5 of the target member. That is, it is preferable to create and transmit planned member request list L3 a predetermined time period before such that the target member is delivered before planned exchange time T7 of the target member. Printer 11 sets planned exchange time T7 and the name of the target member that is required to be exchanged in planned member request list L3, and transmits planned exchange time T7 and the name of the target member to guidance program 68. The timing when planned member request list L3 is transmitted is not limited to the time going back from planned exchange time T7 by the predetermined time period. For example, printer 11 may calculate planned exchange time T7 immediately after the target member is exchanged, and create and transmit planned member request list L3.

Similarly to planned setup list L1 and the like, guidance program 68 sets planned exchange time T7 of planned member request list L3 as device request time T1, sets departure target time T2 and operation start target time T3, and creates operation instruction information 73 (see Fig. 10). As a result, as illustrated in Fig. 9, the delivery of the cream solder or screen mask M can be arranged.

Planned collection request list L4 is a list for requesting a member that is required to be collected along with the changeover. Printer 11 acquires job data JOB of production plan data 75 of the next production, for example, at a time going back from changeover time T6 by a predetermined time period. As will be described later, the predetermined time period is preferably equal to or longer than movement time period T5 because preparation time period T4 is defective when only the collection is performed. That is, a time period in which planned collection request list L4 can be created and transmitted a predetermined time period before is preferable such that the target member can be collected before changeover time T6. Printer 11 detects a member having a name different from the name of the member set in job data JOB used for the next production among the names of the members set in job data JOB of board S currently being produced, that is, a member (an example of a target member of the present disclosure) that is required to be collected in the changeover. Printer 11 sets the name of the detected member and changeover time T6 in planned collection request list L4, and transmits the name of the detected member and changeover time T6 to guidance program 68 via line management device 3 (S11, S12). Guidance program 68 sets changeover time T6 of planned collection request list L4 as device request time T1, and creates operation instruction information 73 in which departure target time T2 is set.

Guidance program 68 changes the display of the operation name in Fig. 9 to the automatic collection or the manual collection for screen mask M that can be automatically collected and the target member (other than screen mask M) that is required to be manually collected, similarly to planned setup list L1 and manual changeover request list L2. For example, guidance program 68 may determine the automatic collection and the manual collection based on the name of the target member in planned collection request list L4, and create operation instruction information 73. As a result, guidance program 68 can set the automatic collection or the manual collection as the operation name of operation instruction information 73 based on the information on planned collection request list L4, and can display whether the target member is the target member that can be collected by automated guided vehicle 5 or the target member that is required to be manually collected by the worker, in a distinguishable manner. Alternatively, printer 11 may set information indicating whether the manual collection or the automatic collection is performed in planned collection request list L4. Similarly to planned setup list L1 and manual changeover request list L2, printer 11 may divide and create planned collection request list L4 into two lists of planned collection request list L4 for the automatic collection and planned collection request list L4 for the manual collection.

Further, when only the collection of the target member is performed, preparation time period T4 in storage 8 is not required. For example, although backup block 39 is used in the previous production, when the backup pin is used in the next production, the manual collection of backup block 39 is required. Alternatively, when the next production can be performed with screen mask M stocked in accommodation device 40, only the automatic collection of screen mask M occurs. In this case, as illustrated in third operation instruction information 73 from the top in Fig. 9, guidance program 68 sets only departure target time T2 without setting operation start target time T3. Departure target time T2 is a time going back from changeover time T6 of planned collection request list L4 by movement time period T5. Further, when only the collection is performed by automated guided vehicle 5, it is not required to set storage 8 as the departure place, and automated guided vehicle 5 can be directed for the collection from any place of the production facility (floor). Therefore, for example, when there is automated guided vehicle 5 that is moving toward storage 8 without carrying anything or automated guided vehicle 5 that stops and stands by in the production facility, guidance program 68 may set a time period required to move automated guided vehicle 5 to printer 11 of the collection destination as movement time period T5. In this case, movement time period T5 and departure target time T2 may be updated in accordance with the movement of automated guided vehicle 5. When the automatic delivery and the automatic collection, or the manual delivery and the manual collection can be collectively performed in one round trip, guidance program 68 may create and display the delivery and the collection as one piece of operation instruction information 73. For example, the operation name may be "automatic delivery/collection", and one piece of operation instruction information 73 may be displayed over two rows.

Unexpected member request list L5 is a list to be used when the exchange of the member is required earlier than expected. As described above, printer 11 estimates planned exchange time T7 of cartridge 36 from the initial capacity, the expected consumption, and the unit production time period of the cream solder, and creates planned member request list L3. However, the cream solder may be consumed faster than expected depending on the temperature, humidity, the shape of squeegee 25, and the like. As described above, printer 11 includes remaining amount detection sensor 36A that detects the remaining amount of the cream solder in cartridge 36. For example, when the remaining amount of the cream solder detected by remaining amount detection sensor 36A is equal to or less than a predetermined threshold amount, printer 11 sets the name of the cream solder in unexpected member request list L5. Further, printer 11 sets the delivery time when the cream solder is required to be delivered in unexpected member request list L5 as unexpected time T8 (see Fig. 10). Printer 11 transmits created unexpected member request list L5 to guidance program 68.

As the predetermined threshold amount, it is preferable to set an amount by which the remaining amount does not become zero until new cartridge 36 is delivered. Specifically, for example, when a time period from a time point when the remaining amount reaches the threshold amount to a time point when the printing is continued and the remaining amount becomes zero is set as a remaining time period, the threshold amount is preferably a threshold amount at which the remaining time period is equal to or longer than a total time period of preparation time period T4 and movement time period T5. The target member requested in unexpected member request list L5 is not limited to the cream solder. For example, when cleaning member 33 is a member (cleaning liquid or the like) consumed at predetermined time periods, the remaining amount of cleaning member 33 may be detected by a sensor or the like, and a request may be made in unexpected member request list L5 when cleaning member 33 is consumed earlier than expected.

Guidance program 68 sets unexpected time T8 of received unexpected member request list L5 as device request time T1, sets preparation time period T4 and movement time period T5, and creates operation instruction information 73. Accordingly, when the consumption of the target member is larger than expected, the delivery can be performed before the target member is completely consumed. Guidance program 68 creates and displays operation instruction information 73 based on lists L1 to L5 for each of multiple production lines 2, and displays operation instruction information 73 on display terminal 6. As illustrated in Fig. 9, a list of operation instruction information 73 of each production line 2 is displayed.

As described above, guidance program 68 sets the time going back from departure target time T2 by preparation time period T4 required for the worker to prepare the target member as operation start target time T3 of the worker. Guidance program 68 displays operation start target time T3 in association with operation instruction information 73. Further, as illustrated in Fig. 9, guidance program 68 instructs display terminal 6 to display a list of multiple pieces of operation instruction information 73 arranged from the top in ascending order of operation start target time T3. As a result, operation instruction information 73 in which earlier preparation start is required, that is, operation instruction information 73 having a higher degree of priority of the preparation can be displayed in order.

In addition, guidance program 68 displays a list of multiple pieces of operation instruction information 73 arranged in ascending order of departure target time T2. As illustrated in Fig. 9, guidance program 68 performs display in ascending order of operation start target time T3 and in ascending order of departure target time T2. For example, guidance program 68 sets the ascending order of operation start target time T3 as a first degree of priority, and then displays operation instruction information 73 having same operation start target time T3 in the ascending order of departure target time T2. Accordingly, operation instruction information 73 in which earlier departure is required, that is, operation instruction information 73 having a higher degree of priority of departure can be displayed in order. When operation start target time T3 is not displayed, guidance program 68 may display operation instruction information 73 in ascending order of departure target time T2. The display order is not limited to the ascending order described above. Guidance program 68 may display operation start target time T3 and departure target time T2 in descending order. Alternatively, guidance program 68 may display operation instruction information 73 in order from the earliest creation time period instead of the ascending order or the descending order.

When guidance program 68 receives selection of operation instruction information 73 in which the worker starts the preparation of the target member among multiple pieces of operation instruction information 73 displayed on the screen of Fig. 9, guidance program 68 displays selected operation instruction information 73 in a distinguishable manner from other operation instruction information 73. For example, display terminal 6 receives, via input section 78, the selection of operation instruction information 73 in which the preparation has been started from the list of operation instruction information 73 illustrated in Fig. 9. For example, when a field of operation start target time T3 of any operation instruction information 73 is selected by the mouse or the keyboard of input section 78, display terminal 6 notifies guidance program 68 of which operation instruction information 73 is selected. Guidance program 68 stores, in instruction **DB** 71, that the preparation of operation instruction information 73 for which the notification is given is started. Guidance program 68 notifies display terminal 6 of an instruction to change the display of selected operation instruction information 73. Fig. 9 illustrates a state where operation instruction information 73 of the cream solder at the bottom is selected. For example, as illustrated in Fig. 9, when display terminal 6 receives a display change instruction from guidance program 68, display terminal 6 changes the color of operation start target time T3 of selected operation instruction information 73 to red or yellow, and displays operation instruction information 73 in a distinguishable manner from other operation instruction information 73. Accordingly, when multiple workers prepare the target member, it is possible to obtain information as to which target member another worker has started preparation of with a difference color in the list. It is possible to suppress double preparation of the target member.

Display terminal 6 may change the display without notifying guidance program 68. Further, guidance program 68 and display terminal 6 need not receive the selection of operation instruction information 73 in which the preparation is started, by input section 78. For example, display terminal 6 may receive the selection of operation instruction information 73 based on the operation of confirming (verifying) whether the target member to be prepared is a correct member. As illustrated in Fig. 1, display terminal 6 includes, for example, barcode reader 6A. Operation guidance system 10 manages each of the target members using a barcode. When the barcode provided on the target member (squeegee 25 or the like) prepared by the worker in storage 8 is read by barcode reader 6A, display terminal 6 may determine that the preparation of operation instruction information 73 matching the type of the target member is completed, and may change the color of matched operation instruction information 73. Accordingly, whether the prepared target member is correct and the completion of the preparation of the target member can be collectively received. Guidance program 68 need not perform the selection of operation instruction information 73 or the change of the display.

In addition, guidance program 68 sets, as departure target time T2, a time going back from device request time T1 by movement time period T5 required for automated guided vehicle 5 to move from the departure place (such as storage 8) to printer 11. Accordingly, it is possible to guide departure target time T2 whose time is advanced after securing required movement time period T5. Automated guided vehicle 5 can be reliably caused to arrive at printer 11 by device request time T1. Guidance program 68 may use, as movement time period T5 of automated guided vehicle 5, a time period required for a person to carry the target member, instead of the time period required for automated guided vehicle 5 to move in the production facility.

In addition, printer 11 estimates changeover time T6 based on the number of produced boards, the number of boards scheduled to be produced, and the unit production time period, and notifies guidance program 68 of changeover time T6 in list L1 or the like. Guidance program 68 sets changeover time T6 of acquired list L1 as device request time T1. As a result, device request time T1 and departure target time T2 can be set in accordance with the actual progress status of the production of printer 11. Guidance program 68 may estimate device request time T1.

In addition, guidance program 68 sets the member required after the changeover (the member of planned setup list L1 and manual changeover request list L2) as the target member required to be delivered, and sets the member not required after the changeover (the member of planned collection request list L4) as the target member required to be collected. Accordingly, it is possible to detect a member that is changed along with the changeover and appropriately set a target member that is required to be delivered and collected.

In addition, when a member that is required to be manually exchanged along with the changeover is set as the target member, guidance program 68 displays that manual exchange is required for operation instruction information 73 of the set target member. As illustrated in Fig. 9, operation guidance system 10 displays text "manual delivery" as the operation name. Accordingly, the worker can easily identify operation instruction information 73 in which the manual exchange is required and operation instruction information 73 in which the automatic exchange is performed. It is possible to consider the setup of the subsequent operation such as whether the worker moves to printer 11 and performs the operation. Guidance program 68 need not display the operation name in Fig. 9.

In addition, in the creation of planned member request list L3, printer 11 calculates a time period obtained by multiplying a predetermined threshold number of boards (the number of boards that requires to be cleaned or the number of boards based on the consumption of the cream solder) by the unit production time period, and sets a time obtained by adding the calculated time period to the current time as planned exchange time T7. Guidance program 68 sets planned exchange time T7 acquired from planned member request list L3 as device request time T1. As a result, it is possible to predict the time to exchange screen mask M that is required to be cleaned each time the threshold number of boards is printed or the cream solder that does not remain, and to notify the worker for the preparation.

(Delivery and Collection of Target Member)

Guidance program 68 receives the start of the delivery and the collection of the target member in the list of operation instruction information 73 illustrated in Fig. 9. As illustrated in Fig. 9, display terminal 6 displays departure button 81 on the right side of each of multiple pieces of operation instruction information 73. When the worker completes the preparation of the target member (screen mask M) of the automatic delivery and sets the target member on automated guided vehicle 5, the worker selects departure button 81 on the right side of set operation instruction information 73 with input section 78 (mouse or the like). Display terminal 6 notifies guidance program 68 of operation instruction information 73 for which departure button 81 is selected. Guidance program 68 causes automated guided vehicle 5 to depart from storage 8 toward printer 11 corresponding to operation instruction information 73 for which the notification is given. Guidance program 68 deletes operation instruction information 73 for which departure button 81 is selected from instruction DB 71. Guidance program 68 notifies display terminal 6 of an instruction to delete the display of operation instruction information 73. As a result, the delivery of one piece of operation instruction information 73 is completed.

Therefore, when display terminal 6 receives the selection of operation instruction information 73 in which the preparation of the target member to be delivered is completed by the worker among multiple pieces of operation instruction information 73, guidance program 68 causes automated guided vehicle 5 to depart from storage 8 toward printer 11. As a result, automated guided vehicle 5 can be caused to depart in response to the completion of the preparation, and the automatic exchange can be performed at an appropriate timing.

Similarly, when the preparation of the target member of the manual delivery is completed and the target member can be carried out, the worker selects right departure button 81 of prepared operation instruction information 73. Guidance program 68 does not remotely operate automated guided vehicle 5, but executes processing of deleting and hiding selected operation instruction information 73 as in a case of the automatic delivery. Accordingly, even in a case of the manual delivery, operation instruction information 73 can be deleted or the like in response to the completion of the preparation by the worker.

Further, when departure button 81 of operation instruction information 73 whose operation name is the automatic collection is selected, guidance program 68 causes automated guided vehicle 5 to depart for the collection of screen mask M that is no longer required, similarly to the automatic delivery. In this case, as described above, when only the collection is performed by automated guided vehicle 5, it is not required to set storage 8 as the departure place, and automated guided vehicle 5 may depart from any place of the production facility (floor). In addition, the worker can select departure button 81 of operation instruction information 73 for the manual collection at the time point when the worker is ready to prepare to perform the collection for operation instruction information 73 of which the operation name is the manual collection, and can go to perform the collection by erasing operation instruction information 73.

In the present embodiment, automated guided vehicle 5 is an example of a conveyance device of the present disclosure. Storage 8 or a position of automated guided vehicle 5 when the collection instruction is given is an example of a departure place. Control device 4 is an example of an operation guidance device. Squeegee 25, cleaning member 33, cartridge 36, backup block 39, and screen mask M are examples of members and a target member. Remaining amount detection sensor 36A is an example of a detection device. Guidance program 68 is an example of a request time acquisition section, a setting section, and a display instruction section. Changeover time T6, planned exchange time T7, and unexpected time T8 of planned setup list L1 and manual changeover request list L2 are examples of a delivery time. Changeover time T6 of planned collection request list L4 is an example of a collection time.

As described above, according to the example described above, the following effects can be achieved.

In one aspect of the present embodiment, guidance program 68 acquires the delivery time (such as changeover time T6 of planned setup list L1) when a new member is required to be delivered to printer 11 and the collection time (changeover time T6 of planned collection request list L4) when a used member is required to be collected (S12). Guidance program 68 sets departure target time T2 when the departure from the departure place (such as storage 8) toward printer 11 is required in time for acquired device request time T1 (S15). Guidance program 68 sets information (the operation name, the work order number, the member type, the member model, and the destination in Fig. 9) of the target member that requires the operation (the delivery or the collection) at device request time T1 corresponding to departure target time T2. Guidance program 68 displays, for operation instruction information 73 in which two pieces of information, set departure target time T2 and the information on the target member, are associated with each other, the list of multiple pieces of operation instruction information 73 on display terminal 6 (S19, S21).

Here, even if the worker of storage 8 advances the preparation in accordance with the production plan of control device 4, in some cases, the actual production operation does not advance in accordance with the production plan because the actual production operation advances faster than expected or is delayed due to the occurrence of the error or the like. In such a case, there is a problem that the production is stopped when the delivery of the exchange member is delayed. In addition, when the delivery is performed too early, there is a problem in that a member remains on site. On the other hand, guidance program 68 acquires lists L1 to L5 from printer 11, sets departure target time T2 and operation start target time T3, and displays departure target time T2 and operation start target time T3 in a list as operation instruction information 73. As a result, the worker can prepare for the progress of the actual production of printer 11. The target member can be delivered and collected more optimally.

The present disclosure is not limited to the above-described embodiment, and it goes without saying that various improvements and changes can be made without departing from the gist of the present disclosure.

For example, in the above-described embodiment, guidance program 68 performs the delivery and the collection of the target member using operation instruction information 73, but may perform only one of the delivery or the collection. Therefore, guidance program 68 may create and display operation instruction information 73 using at least one of five lists L1 to L5.

In the above-described embodiment, printer 11 creates lists L1 to L5, but another device, for example, any of line management device 3, control device 4, or display terminal 6 may acquire required information (the number of produced boards or the like) from printer 11 and create lists L1 to L5.

Although guidance program 68 creates operation instruction information 73, another device, for example, any of line management device 3, printer 11, or display terminal 6 may create operation instruction information 73 in the same manner as guidance program 68.

Operation instruction information 73 is displayed on display terminal 6, but may be displayed on another device, line management device 3, control device 4, or printer 11.

The display screen of the list of operation instruction information 73 illustrated in Fig. 9 is an example. For example, the number of departure buttons 81 may be one. When departure button 81 is selected in a state where departure target time T2 of any operation instruction information 73 is selected among multiple pieces of operation instruction information 73, guidance program 68 and display terminal 6 may perform the departure of automated guided vehicle 5 or the deletion of operation instruction information 73 for selected operation instruction information 73. Further, for example, guidance program 68 may display operation instruction information 73 in which departure target time T2 or operation start target time T3 is a time period before the current time, differently from other operation instruction information 73. That is, operation instruction information 73 delayed from the scheduled time period may be highlighted and displayed.

The contents of the present disclosure are not limited to the dependent relationships described in the claims. For example, the present description also discloses a technical idea in which "the operation guidance device according to Claim 1 or 2" is changed to "the operation guidance device according to any one of Claims 1 to 4" in Claim 5. For example, the present description also discloses a technical idea in which "the operation guidance device according to Claim 1 or 2" is changed to "the operation guidance device according to any one of Claims 1 to 5" in Claim 6. For example, the present description also discloses a technical idea in which "the operation guidance device according to Claim 1 or 2" is changed to "the operation guidance device according to any one of Claims 1 to 7" in Claim 8. For example, the present description also discloses a technical idea in which "the operation guidance device according to Claim 1 or 2" is changed to "the operation guidance device according to any one of Claims 1 to 9" in Claim 10. For example, the present description also discloses a technical idea in which "the operation guidance device according to Claim 1 or 2" is changed to "the operation guidance device according to any one of Claims 1 to 10" in Claim 11.

Reference Signs List

10: operation guidance system, 2: production line, 3: line management device, 4: control device, 5: automated guided vehicle (conveyance device), 8: storage (departure place), 11: printer (screen printer), 25: squeegee (member, target member), 33: cleaning member (member, target member), 36: cartridge (member, target member), 36A: remaining amount detection sensor (detection device), 39: backup block (member, target member), 68: guidance program (request time acquisition section, setting section, display instruction section), 73: operation instruction information, an M: screen mask (member, target member), T1: device request time, T2: departure target time, T3: operation start target time, T4: preparation time period, T6: changeover time (delivery time, collection time), T7: planned exchange time (delivery time), T8: unexpected time (delivery time).

**Claims**

1. An operation guidance device comprising:

   a request time acquisition section configured to acquire, for a member used by a screen printer, a device request time including at least one of a delivery time when a new member is required to be delivered to the screen printer or a collection time when the member used by the screen printer is required to be collected;
   a setting section configured to set a departure target time when a departure from a departure place toward the screen printer is required in time for the device request time acquired by the request time acquisition section, and information on a target member that is the member that requires an operation at the device request time corresponding to the departure target time; and
   a display instruction section configured to, for operation instruction information in which two pieces of information, the departure target time set by the setting section and the information on the target member, are associated with each other, display a list of multiple pieces of the operation instruction information.

2. The operation guidance device according to Claim 1,

   wherein the device request time includes the delivery time,
   the setting section sets a time going back from the departure target time by a preparation time period required for a worker to prepare the target member, as an operation start target time of the worker, and

the display instruction section displays the operation start target time in association with the operation instruction information in addition to the departure target time and the information on the target member, and displays the list of the multiple pieces of operation instruction information arranged in ascending order of the operation start target time.

3. The operation guidance device according to Claim 2, wherein when the display instruction section receives selection of the operation instruction information in which the worker starts the preparation of the target member among the multiple pieces of operation instruction information, the display instruction section displays the selected operation instruction information in a distinguishable manner from other operation instruction information.

4. The operation guidance device according to Claim 1,

wherein the device request time includes both the delivery time and the collection time, and
the display instruction section displays the list of the multiple pieces of operation instruction information arranged in ascending order of the departure target time.

5. The operation guidance device according to Claim 1 or 2,

wherein the target member is conveyed by a conveyance device configured to travel in a production facility in which the screen printer is installed, and
the setting section sets a time going back from the device request time by a movement time period required for the conveyance device to move from the departure place to the screen printer, as the departure target time.

6. The operation guidance device according to Claim 1 or 2,
wherein the request time acquisition section sets, for boards being produced by the screen printer, as the device request time, a changeover time when the production of the board is completed and a changeover for changing a type of the board to be produced occurs, the changeover time being estimated based on the number of produced boards, which is the number of the boards of which the production is completed by the screen printer, the number of boards scheduled to be produced, which is a total number of the boards scheduled to be produced by the screen printer, and a unit production time period required to produce one board.

7. The operation guidance device according to Claim 6,

wherein the device request time includes both the delivery time and the collection time, and
the setting section sets the member required in the screen printer after the changeover as the target member required to be delivered, and sets the member not required in the screen printer after the changeover as the target member required to be collected.

8. The operation guidance device according to Claim 1 or 2,

wherein the device request time includes the delivery time,
the target member is conveyed by a conveyance device configured to travel in a production facility in which the screen printer is installed, and
when the display instruction section receives selection of the operation instruction information in which preparation of the target member to be delivered is completed among the multiple pieces of operation instruction information, the display instruction section causes the conveyance device to depart from the departure place toward the screen printer.

9. The operation guidance device according to Claim 6,

wherein the target member includes the member that is required to be manually exchanged, and
when the member that is required to be manually exchanged along with the changeover in the screen printer is set as the target member by the setting section, the display instruction section displays that manual exchange is required, for the operation instruction information of the set target member.

10. The operation guidance device according to Claim 1 or 2,

wherein the target member includes the member that is required to be exchanged each time a threshold number of boards is produced by the screen printer, and

the request time acquisition section calculates a time period obtained by multiplying the threshold number of boards by a unit production time period required for producing one board in the screen printer, and sets a time obtained by adding the calculated time period to a current time, as the device request time.

11. The operation guidance device according to Claim 1 or 2,

wherein the device request time includes the delivery time,

the screen printer includes a detection device configured to detect a remaining amount of the target member, and

when the remaining amount of the target member detected by the detection device is equal to or less than a predetermined threshold amount, the request time acquisition section sets the delivery time when a new target member is required to be delivered to the screen printer, as the device request time.

12. An operation guidance system comprising:

a screen printer;

a line management device configured to manage a production line in which the screen printer is provided;

a control device connected to each of multiple line management devices and configured to manage a production order in the production line managed by each of the multiple line management devices;

a request time acquisition section configured to acquire, for a member used by the screen printer, a device request time including at least one of a delivery time when a new member is required to be delivered to the screen printer or a collection time when the member used by the screen printer is required to be collected;

a setting section configured to set a departure target time when a departure from a departure place toward the screen printer is required in time for the device request time acquired by the request time acquisition section, and information on a target member that is the member that requires an operation at the device request time corresponding to the departure target time; and

a display instruction section configured to, for operation instruction information in which two pieces of information, the departure target time set by the setting section and the information on the target member, are associated with each other, display a list of multiple pieces of the operation instruction information.

13. The operation guidance system according to Claim 12,

wherein the device request time includes the delivery time,

the setting section sets a time going back from the departure target time by a preparation time period required for a worker to prepare the target member, as an operation start target time of the worker, and

the display instruction section displays the operation start target time in association with the operation instruction information in addition to the departure target time and the information on the target member, and displays the list of the multiple pieces of operation instruction information arranged in ascending order of the operation start target time.

14. An operation guidance method comprising:

a request time acquisition step of acquiring, for a member used by a screen printer, a device request time including at least one of a delivery time when a new member is required to be delivered to the screen printer or a collection time when the member used by the screen printer is required to be collected;

a setting step of setting a departure target time when a departure from a departure place toward the screen printer is required in time for the device request time acquired by the request time acquisition section, and information on a target member that is the member that requires an operation at the device request time corresponding to the departure target time; and

a display instruction step of, for operation instruction information in which two pieces of information, the departure target time set by the setting step and the information on the target member, are associated with each other, displaying a list of multiple pieces of the operation instruction information.

[Fig. 1]

[Fig. 2]

[Fig. 3]

UP
Z AXIS
FRONT ←→ REAR
Y AXIS
DOWN

CARRYING-IN-AND-OUT
DIRECTION

[Fig. 4]

LEFT
X AXIS
FRONT ←→ REAR
Y AXIS
RIGHT

CARRYING-IN-AND-OUT
DIRECTION

[Fig. 5]

[Fig. 6]

[Fig. 7]

[Fig. 8]

PRODUCTION MANAGEMENT PROGRAM — 67

S1 RECEIVE

S19
ACQUIRE OPERATION
INSTRUCTION INFORMATION

10

71 — INSTRUCTION DB

73
73
73

OPERATION INSTRUCTION
INFORMATION

DISPLAY TERMINAL — 6

S21 DISPLAY

75 — PRODUCTION PLAN DATA

· WORK ORDER NUMBER
· JOB NAME
· MODEL
· NUMBER OF BOARDS SCHEDULED
  TO BE PRODUCED
· PRODUCTION START SCHEDULED
  TIME

S3

S17 REGISTER OPERATION
INSTRUCTION INFORMATION

68 — GUIDANCE PROGRAM

S15 CREATE

TRANSMIT EACH LIST

ANOTHER PRODUCTION LINE

S12 TRANSMIT EACH LIST

S7
ACQUIRE PRODUCTION
PLAN DATA

69 — PRODUCTION PLAN DB

75
75
75

PRODUCTION PLAN DATA

LINE MANAGEMENT
DEVICE — 3

S5 REQUEST PRODUCTION PLAN DATA

S9
TRANSMIT PRODUCTION PLAN DATA

S11 TRANSMIT EACH LIST

PLANNED SETUP LIST L1
MANUAL CHANGEOVER REQUEST LIST L2
PLANNED MEMBER REQUEST LIST L3
PLANNED COLLECTION REQUEST LIST L4
UNEXPECTED MEMBER REQUEST LIST L5

PRINTER — 11

[Fig. 9]

| OPERATION NAME | OPERATION START TARGET TIME | WORK ORDER NUMBER | MEMBER TYPE | MEMBER MODEL | DESTINATION | DEPARTURE TARGET TIME |
|---|---|---|---|---|---|---|
| AUTOMATIC DELIVERY | 9:50 | 0001 | MASK | MASK 0 0 1 | LINE A | 10:10 |
| MANUAL DELIVERY | 10:00 | 0001 | BACKUP | BACKUP 0 0 2 | LINE A | 10:20 |
| MANUAL COLLECTION | | 0002 | BACKUP | BACKUP 0 0 3 | LINE B | 10:30 |
| AUTOMATIC DELIVERY | 11:00 | 0003 | MASK | MASK 0 0 2 | LINE C | 11:20 |
| MANUAL DELIVERY | 11:10 | 0001 | SOLDER | SOLDER 0 0 3 | LINE A | 12:10 |
| | | | | | | |

T 3

T 2

73

73

73

8 1

DEPARTURE

8 1

DEPARTURE

DEPARTURE

DEPARTURE

DEPARTURE

[Fig. 10]

PREPARATION TIME PERIOD T4
· CARRY-OUT OF MEMBER
· STIRRING OF SOLDER

MOVEMENT TIME PERIOD T5
· AUTOMATED GUIDED
  VEHICLE
· WORKER

OPERATION START TARGET TIME T3    DEPARTURE TARGET TIME T2    DEVICE REQUEST TIME T1

· CHANGEOVER TIME T6
· PLANNED EXCHANGE TIME T7
· UNEXPECTED TIME T8

## INTERNATIONAL SEARCH REPORT

| International application No. |
| --- |
| **PCT/JP2022/045315** |

| A. | CLASSIFICATION OF SUBJECT MATTER |
| --- | --- |

*B41F 15/00*(2006.01)i; *H05K 13/00*(2006.01)i
FI:   B41F15/00 Z; H05K13/00 Z

According to International Patent Classification (IPC) or to both national classification and IPC

| B. | FIELDS SEARCHED |
| --- | --- |

Minimum documentation searched (classification system followed by classification symbols)

B41F15/00-15/46; H05K13/00-13/08; G05B19/418

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | WO 2021/176502 A1 (YAMAHA MOTOR CO LTD) 10 September 2021 (2021-09-10) entire text, all drawings | 1-14 |
| A | JP 2018-190871 A (PANASONIC IP MAN CORP) 29 November 2018 (2018-11-29) entire text, all drawings | 1-14 |
| A | JP 2014-149730 A (HITACHI LTD) 21 August 2014 (2014-08-21) entire text, all drawings | 1-14 |
| A | US 2015/0045927 A1 (CYBEROPTICS CORPORATION) 12 February 2015 (2015-02-12) entire text, all drawings | 1-14 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **08 February 2023** | **21 February 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/045315**

| Patent document cited in search report | | | Publication date (day/month/year) | Patent family member(s) | | | Publication date (day/month/year) |
|---|---|---|---|---|---|---|---|
| WO | 2021/176502 | A1 | 10 September 2021 | CN 115066996 A entire text, all drawings | | | |
| JP | 2018-190871 | A | 29 November 2018 | US 2018/0329400 A1 entire text, all drawings CN 108882675 A | | | |
| JP | 2014-149730 | A | 21 August 2014 | (Family: none) | | | |
| US | 2015/0045927 | A1 | 12 February 2015 | (Family: none) | | | |

Form PCT/ISA/210 (patent family annex) (January 2015)

**REFERENCES CITED IN THE DESCRIPTION**

**Patent documents cited in the description**

- JP 2018190871 A

- WO 2019225002 A